(19) Europäisches Patentamt / European Patent Office / Office européen des brevets

(11) **EP 1 873 809 A1**

(12) **EUROPEAN PATENT APPLICATION**

(43) Date of publication:
**02.01.2008 Bulletin 2008/01**

(51) Int Cl.:
*H01J 37/34* (2006.01)    *H01F 41/18* (2006.01)
*C23C 14/35* (2006.01)    *G05B 13/00* (2006.01)

(21) Application number: **06116020.6**

(22) Date of filing: **26.06.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **M2 Engineering AB (publ)**
**SE-163 91 Spanga (SE)**

(72) Inventor: **Jäderberg, Jan**
**163 47, Spånga (SE)**

(74) Representative: **Engdahl, Stefan**
**P.O. Box 45086**
**104 30 Stockholm (SE)**

(54) **Sputtering device**

(57)    The present invention relates to a sputtering cathode of the magnetron type and a control method for such a device for, in a vacuum process, depositing very thin films on substrates for a wide variety of commercial and scientific purposes including production of circular optical discs such as CD- or DVD-discs. In particular, the sputtering device comprises a magnet system disposed behind the target and comprising at least three permanent magnets connected to each other by means of a yoke, each of the permanent magnets having a different polarity, wherein the permanent magnets is adapted to interact with each other so as to form a magnetic flux line plateau having magnetic flux lines being substantially parallel with the sputtering surface of the target.

Fig. 1

EP 1 873 809 A1

## Description

TECHNICAL FIELD

The present invention generally relates to sputtering devices for, in a vacuum process, depositing very thin films on substrates for a wide variety of commercial and scientific purposes including production of circular optical discs such as CD- or DVD-discs. The present invention is suitable for e.g. DC sputtering, pulsed DC sputtering, AC sputtering, and RF sputtering. In particular, the present invention relates to a sputtering cathode of the magnetron type and a control method for such a device.

BACKGROUND OF THE INVENTION

Sputtering is a vacuum process used to deposit very thin films on substrates for a wide variety of commercial and scientific purposes. It is generally performed by applying a high voltage across a low-pressure gas (usually argon at about 5 millitorr) to create a plasma, which consists of electrons and gas ions in a low energy plasma state. During the sputtering, ionized gas ions strike a "target", composed of the desired coating material, and cause atoms from that target to be ejected with enough energy to travel to, and bond with, the substrate.

The planar magnetron was introduced in the 1960s and in this technology, magnets are used to confine the "glow discharge" plasma to the region closest to the target surface, which is mounted in a vacuum chamber as will be described hereinafter. Aluminium and pure silver are the most common target materials for full reflective layers while silver alloy, gold and silicon are used for the semi reflective layers when sputtering optic discs. When a voltage at a negative potential of -300 to -1000 VDC is applied to the target, plasma is created below the target and the sputtering process starts. Free electrons collide with sputtering gas atoms, e.g. argon atoms, that ionize and the ions bombard the target due to the Coulomb force. This starts several processes of which the following are the most important for sputtering: Atoms from the target are released and are deposited on the substrate and masks, and so-called secondary electrons are released from the target and are added to the plasma, which will lead to further collisions with gas atoms.

To create as dense plasma as possible, the electrons are encapsulated by a magnetic field which bends their track back towards the target. The interaction between the deflection in the magnetic field and the Coulomb force between the electrons and target sets the electrons in a circulation motion near the surface of the target thereby increasing the possibility of collisions with gas atoms.

The quality demands of the sputtered layer of an optical disc will continuously increase with the development of newer formats while the production cost of the disc will be pressed down when the format is maturing. A high uniformity, i.e. a low thickness deviation, of the sputtered layer is of high importance especially for multi layers when the laser, e.g. in a CD or DVD player, will focus a first layer and thereafter refocus on the next layer and consequently reads through the first layer. Furthermore, it is important to obtain a large number of sputtered discs per target in order to reduce the material cost and the down time of the machine. The number of sputtered discs is a product of mainly the factors given below:

(i)     target utilization, i.e. a percentage of sputtered material compared to the weight of a new target. A high target utilization is important to keep the material cost down and the uptime high (fewer stops for changing of target),

(ii)    target weight, large targets will produce more discs provided a constant target utilization and transfer rate (see below),

and

(iii)   transfer rate, i.e. percentage of sputtered material from the target that actually ends up on the substrate. A high transfer rate is important to keep the material cost down and the uptime high.

Thus, when designing a sputtering device or magnetron it is essential to obtain an optimal trade-off between the above-mentioned main process parameters. It should however be noted that there in fact are more process criteria's that must be taken into consideration, for example, plasma impedance, the precence of re-deposition zones, etc. The problem or dilemma is that the parameters often are in contradiction. For example, a thicker target may produce more discs (but definitely not automatically since the racetrack (see definition below) may be sharper and the target utilization will be reduced) but the target will at the same time come closer to the substrate for a given sputtering device, and the uniformity will be impaired.

In general, a racetrack will be created at a radius where the magnetic field is perpendicular to the electrical field. Consequently, for a flat target, the racetrack will be created where the magnetic field flux have a substantially radial direction since the electrical field is substantially perpendicular to the target surface. The placement of the racetrack in combination with the chamber height (distance between target surface and substrate) will influence the sputtered layer profile on the substrate.

In known sputtering cathodes or magnetrons using two-pole magnet systems, the dilemma is the following. In order to maintain a good uniformity, the distance between the target and the substrate (i.e. the chamber height) must be relatively large but a larger chamber height will decrease the transfer rate and thereby reduce the number of discs produced by a target. The two-pole magnet system creates one racetrack, which will limit the target utilization. Thus, there is basically a trade-off between number of discs per target and the uniformity of the sputtered layer.

Existing magnetrons are sometimes equipped with one or more additional electromagnetic coils to control the magnetic flux from the permanent magnet system. This will allow the user to manipulate the plasma and thereby changing the sputtered layer thickness profile. This can be used to slowly changing the racetrack during a target life or during the sputtering. However, adding one or more coils to the conventional two-pole magnet system gives rise to a number of problems. For example, a very high current density (high power) is needed in order to control the plasma in a way that will result in high uniformity and the ability to move the racetrack is limited. Moreover, when optimizing to obtain a good uniformity the result may be a relatively low target utilization. In addition, one or several electromagnets in combination with a conventional magnet system will move the racetrack by weakening or strengthen the permanent magnet poles. This entail that the possibilities to control the racetrack and thereby the sputtering profile are limited.

In U.S. 4,810,346 such conventional magnetron is described. The magnetron comprises a two permanent magnets of alternately different polarity and an electromagnet is arranged to provide a variable magnetic field to move the racetrack. This conventional sputtering magnetron is impaired with the drawbacks discussed.

In U.S. 5.069.772 and U.S. 5,182,001 another magnetron of the above described conventional type and a coating process for such a magnetron are disclosed, respectively.

Thus, there is a great need of a sputtering device that is capable of achieving a high target utilization at the same time as a good uniformity and a high transfer rate are maintained.

BREIF DESCRIPTION OF THE INVENTION

An object of the present invention is to provide a sputtering device that is capable of uniting a high target utilization with a good uniformity and a high transfer rate and a control process for such a device.

Another object of the present invention is to provide a sputtering device that is capable of producing discs having a high degree of uniformity.

A further object of the present invention is to provide a sputtering device that is capable of handling targets of different thicknesses at maintained good performance with respect to high target utilization, good uniformity and a high transfer rate.

These and other objects are achieved according to the present invention by providing a sputtering device, a method for controlling such a device, a computer program product, which when executed on a computer, performs steps in accordance with the method and a computer readable medium, having the features defined in the independent claim. Preferable embodiments of the invention are characterised by the dependent claims.

As realized by the person skilled in the art, the control method of the present invention, as well as preferred embodiments thereof, are suitable to realize as a computer program or a computer readable medium.

For the purposes of clarification, a number of definitions will be given below:

| | |
|---|---|
| Target: | The source of the material that is deposited on the substrate. |
| Uniformity: | The distribution of the thickness of the sputtered layer. A low thickness deviation will give a high uniformity. |
| Target utilization: | The percentage of sputtered material weight for a used target compared to a new target. |
| Transfer rate: | Percentage of sputtered material that end up on the substrate. |
| Substrate: | Object to be coated, for example, an optically readable disc such as a DVD. |
| Chamber height: | Distance between the target surface and the substrate. |
| Racetrack: | The area where the erosion is most intensive. |
| Anode coordinate: | The point where the magnetic flux lies crosses the ground potential. |
| Re-deposition zone: | Area where the re-scattered rate of sputtered atoms on the target is higher than the sputtering rate. |

According to an aspect of the present invention, there is provided a sputtering device for coating substrates by means of cathode sputtering an annular target having a sputtering surface comprising a magnet system disposed behind the target and comprising at least three permanent magnets connected to each other by means of a yoke, each of the permanent magnets having a different polarity, wherein the permanent magnets is adapted to interact with each other so as to form a magnetic flux line plateau having magnetic flux lines being substantially parallel with the sputtering surface of the target.

According to a second aspect of the present invention, there is provided a control process for a sputtering device for coating substrates by means of cathode sputtering an annular target having a sputtering surface comprising a magnet system disposed behind the target and comprising at least three permanent magnets connected to each other by means of a yoke, each of the permanent magnets having a different polarity, wherein the permanent magnets is adapted to interact with each other so as to form a magnetic flux line plateau having magnetic flux lines being substantially parallel with the sputtering surface of the target, the process comprising the step of: performing an evolutionary computing process to obtain a set of system parameters such that a desired performance with respect of at least one predetermined target parameter can be achieved during a sputtering process.

Thus, the present invention is based on the idea of designing the permanent magnets of the magnet system such that the generated magnetic field is shaped so that the field lines will be substantially flat along a substantial part of the radial length of the sputtering surface of the target, i.e. the field lines are substantially parallel to the sputtering surface of the target. Thereby, a broad erosion profile can be created in the target surface, which, in turn, entails a high degree of target utilization.

In a preferred embodiment, the sputtering device according to the present invention comprises an electromagnet (for example an annularly closed electromagnet), a power supply adapted to supply the electromagnet with an excitation current, and wherein the electromagnet, when being supplied with the excitation current, is adapted to generate an additional magnetic field that superposes the magnetic field caused by the permanent magnets such that the plateau can be tilted and a racetrack can be shifted towards an inner edge of the target or towards an outer edge of the target depending on the direction of the supplied excitation current. This can be achieved due to the fact that the base field, generated by the permanent magnets, creates a large volume where the electrons can move relatively freely. This state will easily be disturbed by a superposed magnetic field generated by the electromagnet. By applying the excitation current in a first direction will move the erosion zone or the racetrack along the radius in a direction outwards and by altering the direction of the excitation current to a second direction reversed to the first, the racetrack is moved inwards in the radial direction. Thereby, it is possible to move the erosion zone, i.e. the racetrack, towards the inner or the outer edge of the target and hence obtain a higher target utilization since also target material nearer the edges can be utilized.

An advantage of the sputtering device according to the present invention comprising an electromagnet is that the erosion zone can be moved using a low excitation current in the electromagnet. Consequently, the cooling requirements are low in comparison the known technique and the energy consumption can be reduced.

According to an embodiment, the permanent magnets are arranged to interact with each other so as to form a magnetic flux line plateau whereby a target erosion zone including at least two race tracks is created. Hence, the flattened magnetic field creates two racetracks. This is based on the insight that the flattened magnetic field, at a certain distance from the permanent magnets, creates a broad potential plateau where the electrons can move relatively free. The electrons will ionize the sputtering gas over a broader surface of the target and the impact into and sputtering from the target will consequently be over a larger surface.

According to an embodiment of the present invention, the permanent magnets are adapted to interact with each other so as to form a magnetic flux line plateau having flux lines being substantially parallel with the sputtering surface of the target, wherein a zone of target erosion with a radial width being substantially equal to or at least as wide as a radial width of the plateau is created during a sputtering process. Consequently, a high target utilization can be achieved since the sputtering gas can be ionized over a broad surface of the target and thus the sputtering can occur over a broad surface.

In a further embodiment according to the present invention, the magnetic field plateau has a length of approximately ½ r, r being the radius of the target.

The features that characterize the invention, both as to organization and to method of operation, together with further objects and advantages thereof, will be better understood from the following description used in conjunction with the accompanying drawings. It is to be expressly understood that the drawings are for the purpose of illustration and description and is not intended as a definition of the limits of the invention. These and other objects attained, and advantages offered, by the present invention will become more fully apparent as the description that now follows is read in conjunction with the accompanying drawings.

BRIEF DESCRIPTION OF THE DRAWINGS

In the following detailed description, reference will be made to the accompanying drawings, of which:

Fig. 1    is a cross-sectional view of an embodiment of the sputtering device according to the present invention.

Fig. 2       is a cross-sectional view of another embodiment of the sputtering device according to the present invention.

Fig. 3a      is a cross-sectional view of an embodiment of the sputtering device according to the present invention showing the generated magnetic field from the permanent magnets.

Fig. 3b      is a cross-sectional view of another embodiment of the sputtering device according to the present invention showing the generated magnetic field from the permanent magnets.

Fig. 4a      is a cross-sectional view of an embodiment of the sputtering device according to the present invention showing the generated magnetic field from the permanent magnets.

Fig. 4b      is a cross-sectional view of the embodiment of the sputtering device according to the present invention of Fig. 4a showing the generated magnetic field from the permanent magnets and the electromagnet supplied with a positive excitation current.

Fig. 4c      is a cross-sectional view of the embodiment of the sputtering device according to the present invention of Fig. 4a showing the generated magnetic field from the permanent magnets and the electromagnet supplied with a negative excitation current.

Fig. 5       is graph showing the erosion profile of a target during a sputtering process.

Fig. 6       is a flow chart showing step of the control method according to the present invention for controlling the sputtering process of a sputtering device according to the present invention.

## DETAILED DESCRIPTION OF THE INVENTION

In the following, the present invention will hereinafter be discussed with respect to preferred embodiments a sputtering cathode for, in a vacuum process, depositing very thin films on substrates for a wide variety of commercial and scientific purposes including production of circular optical discs such as CD- or DVD-discs. The present invention is suitable for e.g. DC sputtering, pulsed DC sputtering, AC sputtering, and RF sputtering.

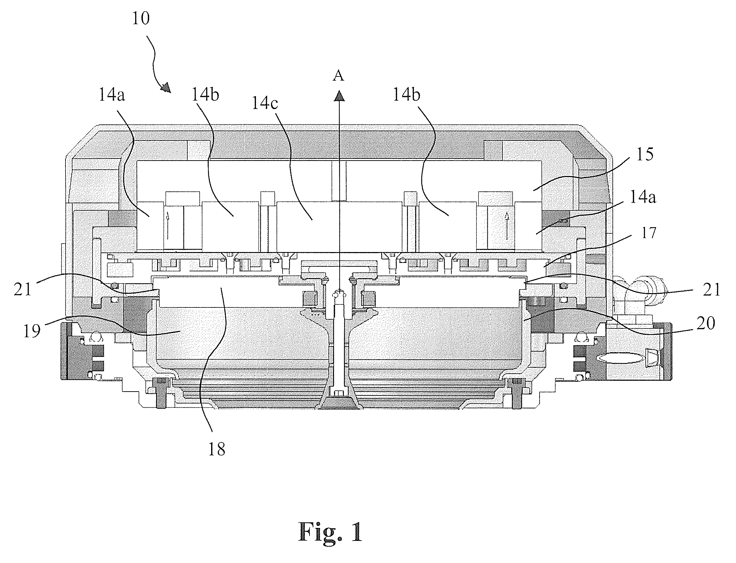

With reference first to Fig. 1-3, preferred embodiments of the present invention will be described. The same reference numerals will be used for the same or similar part throughout the different figures.

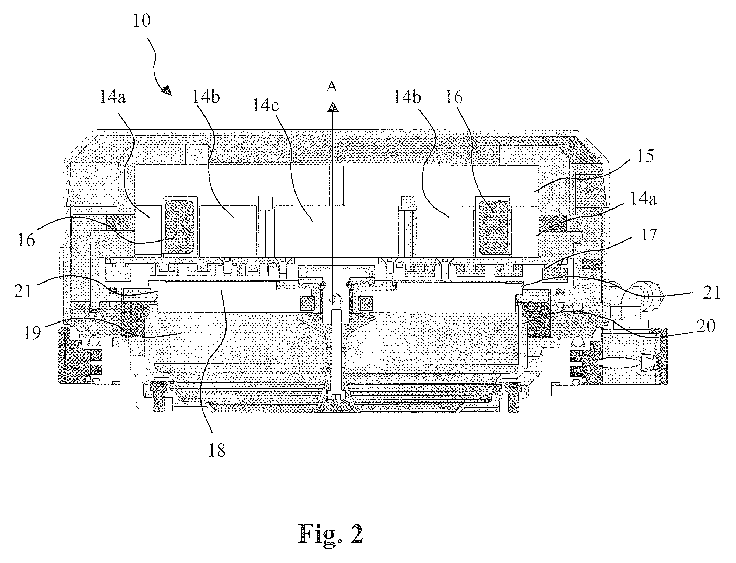

The sputtering cathode 10 comprises a magnets system 12 including a plurality of magnet units 14a-14c situated one inside the other with respect to the axis A, and all consisting of a permanent magnetic material. In one embodiment of the present invention, the magnet system 12 includes an outer permanent magnet 14a, a middle permanent magnet 14b, and an inner permanent magnet 14c interconnected by means of a magnet system backing plate or yoke 15. According to one embodiment (see Fig. 2), an annularly closed electromagnet 16 is arranged between the outer magnet 14a and the inner magnet 14b and is connected to a power supply (not shown) adapted to supply the electromagnet with an excitation current. A cooling plate 17 including cooling channels is arranged to cool the device. A target 18 can be placed in the vacuum chamber 19 partly surrounded by an anode wall 20 connected to ground (not shown). The anode wall 20 includes an anode point 21, which is the point where the magnetic flux lines caused by the permanent magnets crosses the ground potential. In one embodiment, this anode point 21 is located such that the plateau having a length of approximately ½ r or less, r being the radius of the target, is obtained.

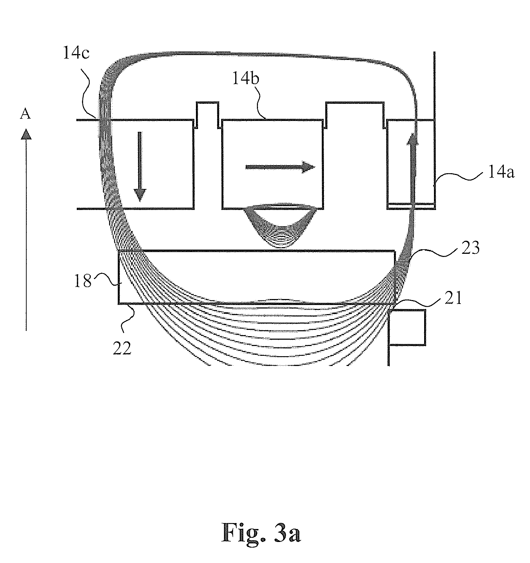

The outer magnet 14a and the middle magnet 14b may be composed of a number of magnet segments whose faces of like polarity are arranged substantially rotational symmetric. The inner magnet 14c may be shaped as a disc. The pole of the outer magnet 14a is oriented such that the direction of the magnetic flux points away from the target 18 and the pole of the inner magnet 14c is oriented such that the direction of the magnetic flux points at the target 18. The middle magnet 14b is oriented in such that the direction of the magnetic flux points in a radial direction facing the outer magnet 14a, see Fig. 3a.

In one embodiment, the permanent magnets may have the following dimensions: the inner magnet 14c may have a diameter of about 60 mm, the middle magnet 14b may have an inner radius of about 40 mm and an outer radius of about 63 mm, and the outer magnet 14a may have an inner radius of about 87 mm and an outer radius of about 100 mm. Furthermore, the electromagnet may have an inner radius of about 69 mm and an outer radius of about 86 mm.

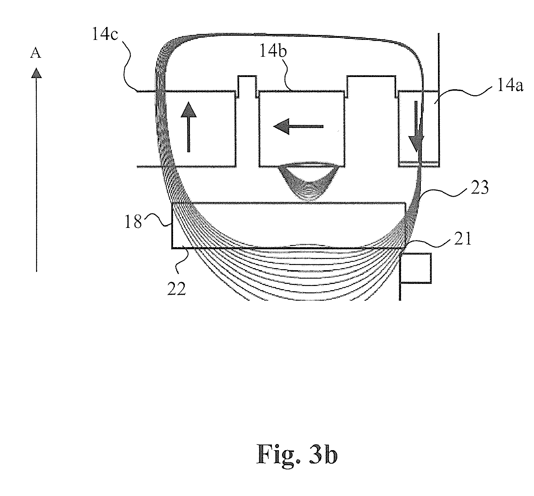

According to another embodiment, see Fig. 3b, the pole of the outer magnet 14a is oriented such that the direction of the magnetic flux points at the target 18 and the pole of the inner magnet 14c is oriented such that the direction of the magnetic flux points away from the target 18. The middle magnet 14b is oriented in a radial direction such that the direction of the magnetic flux faces the inner magnet 14c.

As the skilled man realizes, there are a number of conceivable alternative constructions of the magnetron. For example, the magnetron may have a square-shaped design.

In Figs. 3a and 3b, the magnetic field generated by the permanent magnets according to embodiments of the present invention are shown. It should be noted that only the right side of the axially symmetric sputtering device shown in Fig. 1 and 2 are shown in Figs. 3-6.

As can be seen from Fig. 3a, the magnetic field is shaped such that the field lines 23 are substantially parallel to the target surface 22. In fact, two race tracks are created such that a broad potential plateau is created where the electrons can move relatively freely. The electrons will ionize the sputtering gas, e.g. Argon, over a broad surface of the target 18 and the impact into and sputtering from the target will consequently take place over a significant part of the target. Thereby, an erosion zone that stretches over a significant part of the target can be created.

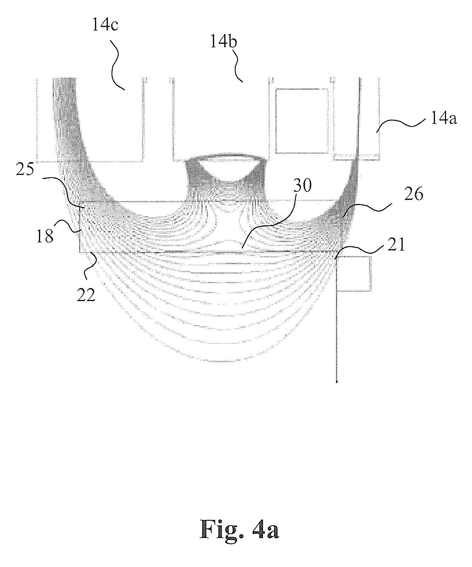

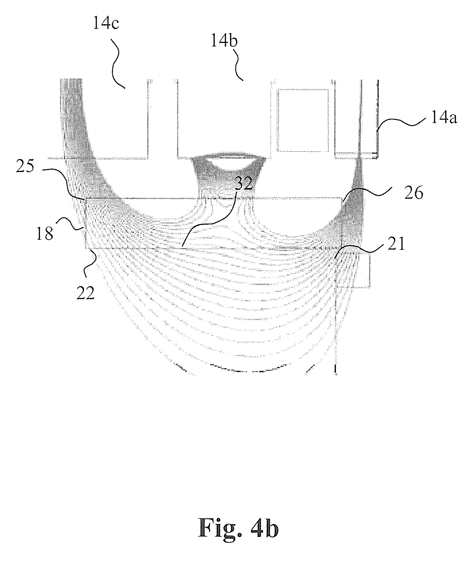

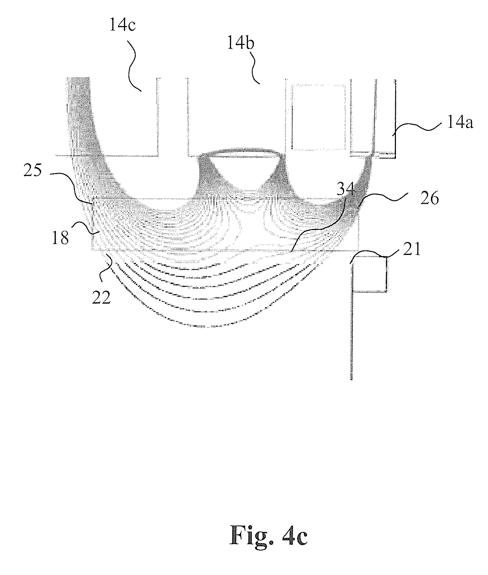

Referring now to Figs. 4a-4c, the interaction between the electromagnet and the permanent magnets will be discussed by means of examples. The electromagnet 16 is adapted to, when being supplied with an excitation current, disturb the base field generated by the permanent magnets 14a-14c such that the erosion zone is moved, se Figs. 4a-4c. To elaborate, the electromagnet 16, when being supplied with an excitation current, is adapted to generate an additional magnetic field that superposes the magnetic field caused by the permanent magnets such that the magnetic field plateau can be tilted towards an inner edge 25 of the target or towards an outer edge 26 of the target depending on a direction of the supplied excitation current. In Fig. 4a, the electromagnet 16 is switched off and a plateau 30 with a center at radius 55 mm is created. In Fig. 4b, the electromagnet is supplied with a current density of 3 *A/mm$^2$*. The magnetic field lines 32 are tilted inwards to the inner edge 25 of the target 18 and a racetrack 32 at radius 18 mm is created. In Fig. 4c, the applied current has an opposite direction, i.e. -3 *A/mm$^2$* and the magnetic field lines 34 are tilted outwards to the outer edge 26 of the target 18. This will create a racetrack 34 at a radius of 70 mm.

A method for controlling the sputtering process in a sputtering device according to the present invention will now be described. A sputtering process is complex process in which a large number of different parameters, internal as well as external, effects the sputtered layer. Examples of internal parameters are:

- *Target erosion.* When the target erodes, both the magnetic and electric field will change and so will the angle of impact on the target. This will change the sputtered thickness profile during the lifetime of a target.
- *Target material atomic weight.* The atomic weight of the sputtered material will have an effect upon the sputtered profile. A heavier atom will be less effected by the collision with the sputtering gas on the transfer from the target to the substrate.
- *Target material distribution angle.* Different target material will have different angular sputtering distribution for a given impact of ions. This will have a direct effect upon the sputtered layer profile.
- Power: Voltage will change with power and thereby the electric field.
- Argon flow will change the argon pressure that will influence the transfer for the atom from the target to the substrate and the uniformity of the layer. The amount of argon will also change the impedance of the plasma.
- Total energy is close to proportional to the average layer thickness
- Vacuum conditioning, i.e. how long time the vacuum system is effective between the sputtering, will effect transfer rate, plasma impedance and uniformity on the layer.
- Mask shape. The shape of the mask may differ and different customers may require different masks, which may effect the layer profile due to "shadowing effects".
Furthermore, a mask that has been coated for a long time will "shadow" part of the substrate and thereby change the uniformity of the sputtered layer.
- Anode. The anode will be coated and directly effect the plasma.
- Cooling water temperature and flow will effect the temperature on the target and thereby the sputtering yield and emission of secondary electrons.

Examples of external parameters are:

- Temperature
- Humidity in the machine. Water will stick to the substrate (water and PC are both highly polar). The water will evaporate in the chamber and be active inside the plasma.
- Humidity of the plastic substrate from the moulding machine will effect in the same way as humidity in the machine.

Consequently, the sputtering process is a very complex process involving large number of variables.

A preferred control process for the sputtering device according to the present invention is a so called evolutionary computing algorithm. Evolutionary computing, EC, is a method for optimizing very complex problems. EC will generate different generations of different settings instead of trying to analyze which parameters and in which way they may effect one or more studied parameters. According to EC, a first generation with a number of individuals is randomly computed but within certain predetermined frames. The generation will be effectuated, measured and a grade will be calculated for each individual with respect to their performance. The individuals with the best performance will be sent to "mating pool". By mixing the different parameters (genes) from the individuals in the mating pool (and by letting them varying slightly or even to mutate) a new generation will be generated. Tests have shown the already after three generations with a population of 100 individuals, very good performance of the sputtering process has been achieved. EC will optimize the sputtering process regardless of how the different parameters are related to each other. The algorithm may be adapted to change the input parameters to compensate for variations in, for example, temperature, humidity or erosion of the target.

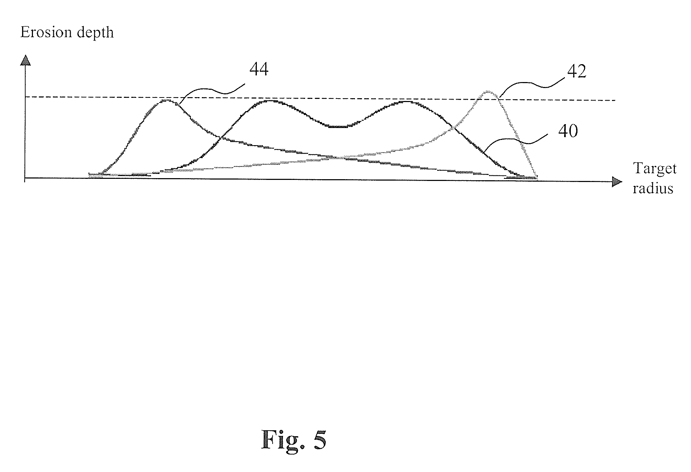

In the control process according to the present invention, the thickness deviation (uniformity) is measured continuously at a number of different radiuses and thus the process is optimized with respect to the uniformity. This is performed by moving the erosion zone over the target surface, i.e. by allowing the control process to freely move the racetrack or racetracks over the target surface or by adjusting the magnetic field by means of the electromagnet and thereby sputter with racetracks outside the erosion profile generated by the permanent magnets. An example will be described below with reference to Fig. 5. According to this example, sputtering during 5 hours (with all parameters fixed) with only the permanent magnets will erode the target at the racetracks about 1 mm, as indicated by the line 40 in Fig. 4. It was found that it demanded about 1 hour to erode the target 1 mm with the electromagnet supplied with an excitation current in the positive direction, i.e. at a current density of 3 $A/mm^2$, see line 42. Furthermore, it was also found that it required about 1.5 hours to erode about 1 mm with the electromagnet supplied with an excitation current in the negative direction, i.e. at a current density of -3 $A/mm^2$, see line 44. As indicated by lines 42 and 44, respectively, the electromagnet will affect the generated magnetic field such that the erosion occurs over a significant part of the target. Since the erosion caused by the electromagnet will take place where the permanent system only causes a little erosion, the sputtering times when the electromagnet is supplied with a positive or negative excitation current may be limited. In one embodiment, these time periods are limited according to the following:

- Max percentage of time in positive direction:

$$100*1/(1+1,5+5) = 13\%.$$

- Max percentage of time in negative direction:

$$100*1,5/(1+1,5+5) = 20\%$$

Thus, the sputtering uniformity will be optimised at the same time as an increased target utilization is secured.

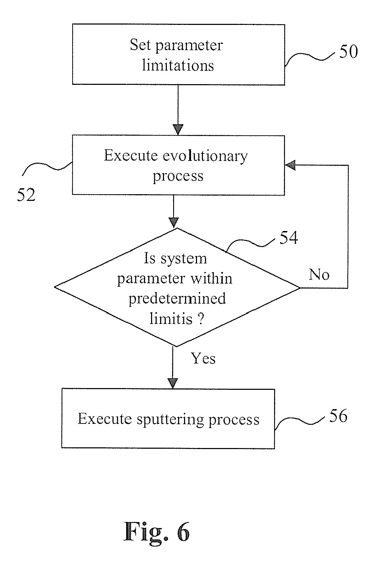

With respect now to Fig. 6, a high-level description of the control method according to the present invention will be discussed. First, at step 50, computing limitations may be set, for example, max percentage of time in positive direction and max percentage of time in negative direction as described above. Then, at step 52, the evolutionary computing process can be initiated and executed as discussed above in order to identify an adequate set of parameters. System parameters can be monitored continuously or after each evolution generation in step 54 in order to check whether the output from the sputtering process is within predetermined requirements. In this embodiment, the uniformity, or thickness deviation, is checked at a number of different radiuses. If it is found that the uniformity is not within the predetermined limits, the evolutionary computing process is continued. On the other hand, if it is found that the uniformity is within the predetermined requirements, the control algorithm may proceed and initiate the actual sputtering process at step 56. During the sputtering process, the uniformity may be monitored continuously in order to check that it is within the predetermined limitations. The parameter setting identified by the evolutionary computing algorithm may have to be adjusted during the process in order to compensate for variations in, for example, temperature, humidity, or erosion of the target.

Although an exemplary embodiment of the present invention has been shown and described, it will be apparent to those having ordinary skill in the art that a number of changes, modifications, or alterations to the inventions as described herein may be made. Thus, it is to be understood that the above description of the invention and the accompanying drawings is to be regarded as a non-limiting example thereof and that the scope of protection is defined by the appended patent claims.

**Claims**

1. A sputtering device for coating substrates by means of cathode sputtering an annular target having a sputtering surface comprising

   a magnet system disposed behind said target and comprising at least three permanent magnets connected to each other by means of a yoke, each of said permanent magnets having a different polarity, wherein said permanent magnets is adapted to interact with each other so as to form a magnetic flux line plateau having magnetic flux lines being substantially parallel with said sputtering surface of said target.

2. The sputtering device according to claim 1, wherein said magnet system further comprises

   an electromagnet connected to a power supply adapted to supply said electromagnet with an excitation current; and

   wherein said electromagnet, when being supplied with said excitation current, is adapted to generate an additional magnetic field that superposes the magnetic field caused by the permanent magnets such that said plateau can be tilted towards an inner edge of said target or towards an outer edge of said target depending on a direction of said supplied excitation current.

3. The sputtering device according to claim 1 or 2, wherein said permanent magnets are adapted to interact with each other so as to form a magnetic flux line plateau having flux lines being substantially parallel with said sputtering surface of said target, wherein a zone of target erosion with a radial width being substantially equal to or at least as wide as a radial width of said plateau is created during a sputtering process.

4. The sputtering cathode according to claim 1, 2 or 3, wherein said permanent magnets are arranged to interact with each other so as to form a magnetic flux line plateau whereby a target erosion zone including at least two race tracks is created.

5. The sputtering device according to any one of claims 1-4, wherein said plateau has a length of approximately ½ r, r being the radius of said target.

6. The sputtering device according to claim 5, wherein said plateau has a length of approximately ½ r or less, r being the radius of said target.

7. The sputtering device according to claim 5 or 6, wherein a point where the magnetic flux lines caused by said permanent magnets crosses a ground potential is located such that said plateau having a length of approximately ½ r or less, r being the radius of said target, is obtained.

8. The sputtering cathode according to any one of preceding claims, wherein said permanent magnet system comprises at least three annular permanent magnets comprising a middle annular magnet arranged between an outer annular magnet and an inner magnet, said middle annular magnet being arranged to influence the magnet field caused by the permanent magnets such that said magnetic flux line plateau having flux lines being substantially parallel with said sputtering surface of said target is formed.

9. The sputtering cathode according to claim 8, wherein said middle magnet is oriented such that the direction of the generated magntic flux is radial and wherein said outer and said inner magnets are oriented such that the direction of the generated magntic flux is respective perpendicular directions with respect to the magnetic flux of said middle magnet.

10. The sputtering device according to any one of preceding claims 2-9, wherein said electromagnet, when being supplied with said excitation current, is adapted to superpose an additional magnetic field over the field caused by the permanent magnets such that a magnitude of said shift towards said inner edge or towards said outer edge is determined by the current density of said excitation current.

11. A control process for a sputtering device for coating substrates by means of cathode sputtering an annular target having a sputtering surface comprising a magnet system disposed behind said target and comprising at least three permanent magnets connected to each other by means of a yoke, each of said permanent magnets having a different polarity, wherein said permanent magnets is adapted to interact with each other so as to form a magnetic flux line plateau having magnetic flux lines being substantially parallel with said sputtering surface of said target, said process comprising the step of: performing an evolutionary computing process to obtain a set of system parameters such that a desired performance with respect of at least one predetermined target parameter can be achieved during a sputtering process.

12. The process according to claim 11, wherein said magnet system further comprises

  an electromagnet connected to a power supply adapted to supply said electromagnet with an excitation current; and

  wherein said electromagnet, when being supplied with said excitation current, is adapted to generate an additional magnetic field that superposes the magnetic field caused by the permanent magnets such that said plateau can be tilted towards an inner edge of said target or towards an outer edge of said target depending on a direction of said supplied excitation current.

13. The process according to claim 11 or 12, wherein said predetermined system parameter is the uniformity of said target.

14. The process according to claim 11, 12 or 13, further comprising the step of: setting evolutionary computing limitations.

15. The process according to claim 11, 12 or 13, further comprisin the steps of:

  continously monitoring said system parameter; and
  if said target parameter is found to not fulfil said desired performance, automatically adjusting said system parameters by means of said evolutionary computing process.

16. A computer program product, which when executed on a computer, performs steps in accordance with any one of claim 11-15.

17. Computer readable medium comprising instructions for bringing a computer to perform a method according to any one of the preceding claims 11-15.

Fig. 1

Fig. 2

Fig. 3a

EP 1 873 809 A1

Fig. 3b

EP 1 873 809 A1

**Fig. 4a**

Fig. 4b

Fig. 4c

Fig. 5

```
┌─────────────────────┐
│   Set parameter     │ ⌒ 50
│   limitations       │
└─────────────────────┘
           │
           ▼
┌─────────────────────┐
│ Execute evolutionary│ ◄─────┐
52 ⌒│     process         │       │
└─────────────────────┘       │
           │                   │
           ▼                   │
        ╱‾‾‾‾‾‾‾‾╲  ⌒ 54        │
       ╱  Is system ╲          │
      ╱ parameter within╲  No  │
      ╲ predetermined  ╱───────┘
       ╲   limitis ?  ╱
        ╲_____╱
           │
           │ Yes
           ▼
┌─────────────────────┐
│Execute sputtering process│ ⌒ 56
└─────────────────────┘
```

Fig. 6

**European Patent Office**

## EUROPEAN SEARCH REPORT

Application Number

EP 06 11 6020

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 97/03220 A (CVC PRODUCTS, INC) 30 January 1997 (1997-01-30) | 1-10 | INV. H01J37/34 |
| A | * the whole document * | 11-17 | H01F41/18 C23C14/35 |
| A | GB 2 393 321 A (* GENCOA LIMITED) 24 March 2004 (2004-03-24) * the whole document * | 1-17 | G05B13/00 |
| A | US 2005/274610 A1 (ISEKI TAKAYUKI) 15 December 2005 (2005-12-15) * the whole document * | 1-17 | |
| A,D | US 5 182 001 A (FRITSCHE ET AL) 26 January 1993 (1993-01-26) * the whole document * | 1-17 | |
| A,D | US 4 810 346 A (WOLF ET AL) 7 March 1989 (1989-03-07) * the whole document * | 1-17 | |
| A | Z. MICHALEWICZ, D. DASGUPTA, R. G. LE RICHE AND M. SCHOENAUER: "Evolutionary Algorithms for Constrained Engineering Problems" COMPUTER IND. ENGNG, vol. 30, no. 4, 1996, pages 851-870, XP002414775 * the whole document * | 11-17 | TECHNICAL FIELDS SEARCHED (IPC) H01J H01F C23C G05B |

The present search report has been drawn up for all claims

| Place of search | Date of completion of the search | Examiner |
|---|---|---|
| Munich | 15 January 2007 | Swiatek, Ryszard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................
& : member of the same patent family, corresponding document

EPO FORM 1503 03.82 (P04C01)

European Patent
Office

Application Number

EP 06 11 6020

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION SHEET B**

Application Number

EP 06 11 6020

The Search Division considers that the present European patent application does not comply with the requirements of unity of invention and relates to several inventions or groups of inventions, namely:

1. claims: 1-10

    A sputtering device with a magnet system.
    ---

2. claims: 11-17

    A method for optimization a control of sputtering process in the device of claim 1 by applying evolutionary computation techniques.
    ---

## ANNEX TO THE EUROPEAN SEARCH REPORT
## ON EUROPEAN PATENT APPLICATION NO.

EP 06 11 6020

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2007

| Patent document cited in search report | | Publication date | Patent family member(s) | | Publication date |
|---|---|---|---|---|---|
| WO 9703220 | A | 30-01-1997 | GB | 2319262 A | 20-05-1998 |
| | | | JP | 11509273 T | 17-08-1999 |
| GB 2393321 | A | 24-03-2004 | NONE | | |
| US 2005274610 | A1 | 15-12-2005 | NONE | | |
| US 5182001 | A | 26-01-1993 | NONE | | |
| US 4810346 | A | 07-03-1989 | DE | 3727901 A1 | 02-03-1989 |

EPO FORM P0459

For more details about this annex : see Official Journal of the European Patent Office, No. 12/82

**EP 1 873 809 A1**

## REFERENCES CITED IN THE DESCRIPTION

### Patent documents cited in the description

- US 4810346 A
- US 5069772 A
- US 5182001 A